Europäisches Patentamt

European Patent Office

Office européen des brevets

(19)

(11) **EP 0 424 835 B1**

(12) **EUROPEAN PATENT SPECIFICATION**

(45) Date of publication and mention
of the grant of the patent:
**21.08.1996 Bulletin 1996/34**

(51) Int Cl.⁶: **H05K 9/00**, H01L 39/24

(21) Application number: **90120193.9**

(22) Date of filing: **22.10.1990**

(54) **Superconducting magnetic shield and process for preparing the same**

Supraleitende magnetische Abschirmung und Verfahren zu ihrer Herstellung

Blindage magnétique supraconducteur et son procédé de fabrication

(84) Designated Contracting States:
**DE FR GB**

(30) Priority: **23.10.1989 JP 275539/89**
**23.03.1990 JP 71863/90**

(43) Date of publication of application:
**02.05.1991 Bulletin 1991/18**

(73) Proprietor: **NIPPON STEEL CORPORATION**
**Tokyo 100 (JP)**

(72) Inventors:
• **Itoh, Ikuo, c/o Nippon Steel Corp., R&D Lab.-I**
**Kawasaki-shi, Kanagawa (JP)**
• **Matsuda, Shoichi, c/o Nippon Steel Corp.,**
**R&D Lab.**
**Kawasaki-shi, Kanagawa (JP)**
• **Minamino, Shigeru, c/o Nippon Steel Corp.,**
**Hikari-shi, Yamaguchi, (JP)**
• **Shimizu, Tsunehiro, c/o Nippon Steel Corp.,**
**Hikari-shi Yamagushi, (JP)**
• **Sasaki, Tsutomu, c/o Nippon Steel Corp., R&D**
**Kawasaki-shi, Kanagawa (JP)**

(74) Representative: **VOSSIUS & PARTNER**
**Postfach 86 07 67**
**81634 München (DE)**

(56) References cited:
EP-A- 0 365 171          FR-A- 2 613 115
FR-A- 2 627 005          GB-A- 2 215 847

• SOVIET PHYSICS TECHNICAL PHYSICS. vol. 23,
no. 8, September 1978, NEW YORK US pages
1100 - 1103; B.V. VASIL EV AND AL: 'SHIELDING
OF WEAK MAGNETIC FIELDS BY
SUPERCONDUCTING SHELLS'

Note: Within nine months from the publication of the mention of the grant of the European patent, any person may give
notice to the European Patent Office of opposition to the European patent granted. Notice of opposition shall be filed in
a written reasoned statement. It shall not be deemed to have been filed until the opposition fee has been paid. (Art.
99(1) European Patent Convention).

## Description

The present invention relates to a Nb-Ti-base alloy superconducting magnetic shield. More particularly, the present invention relates to a seamless magnetic shield in a hollow body form comprising a multilayer composite laminate composed of an Nb-Ti-base alloy layer and a metal layer having a high conductivity.

In theory, a superconductor in the form of a hollow vessel having a bottom, or a hollow body not having a bottom, can provide a good shielding of the inside thereof from a magnetic field until the strength of an external magnetic field reaches a certain value. This is because a superconducting shielding current flows in the superconductor in a closed loop and generates a magnetic flux which cancels the total amount of flux in a closed loop caused by an external field, and thus a magnetic field in the opposite direction is formed and the inside of the vessel becomes a low field region. Accordingly, various magnetic shields having the above-described shape have been proposed, and some are in practical use. The prior art will now be described.

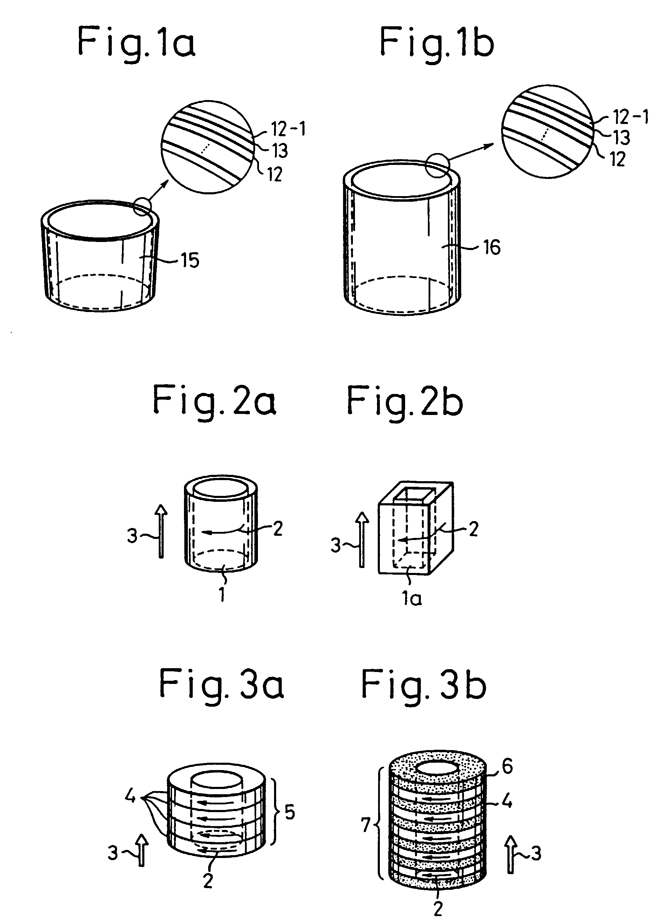

(1) An Nb block is cut to form a cylinder 1 not having a bottom, as shown in Fig. 2(a), or a tetragonal hollow body la as shown in Fig. 2(b), and these bodies are used for a magnetic shielding of a sensor section of a SQUID magneto meter used for the measurement of a small magnetic field. For example, in this case, a superconducting shielding current 2 flows in a closed loop in a direction perpendicular to the direction of an external magnetic field 3, to thereby form a magnetic field, and thus reduce the external magnetic field.

(2) As shown in EP-A-0 365 171 and in Fig. 3, a superconductor in a sheet or foil form is formed into a doughnut-like disk 4 having a hole in the center thereof, and disks having the same shape are laminated one on top of the other to form a cylinder 5. Alternatively, the lamination is conducted while sandwiching a normal conductor 6 having the same shape as the disk, to form a cylinder 7. In this case, since a superconducting shielding current 2 flows only through superconducting disks, the cylinder 7 can shield only external fields parallel to axis.

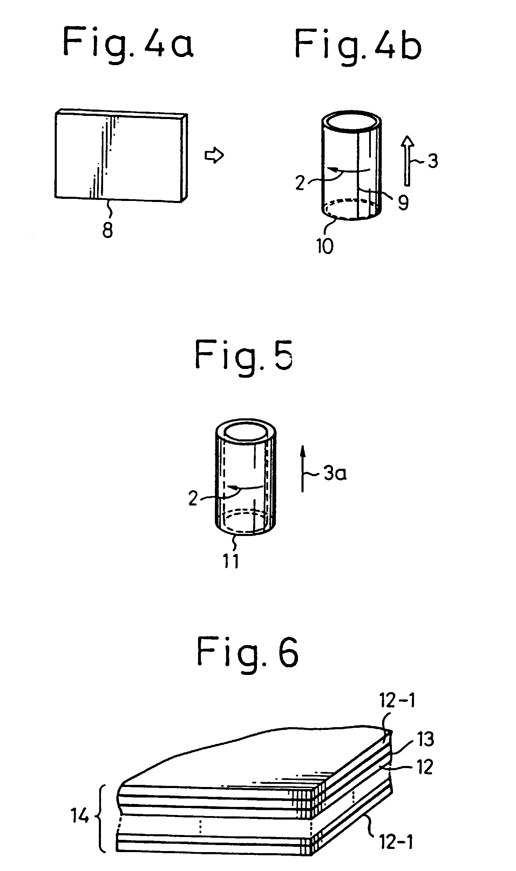

(3) As shown in Fig. 4, a superconductor 8 in a square plate or foil form is cylindrically bent, and the meeting edges are connected to each other. In this case, a superconducting shielding current 2 forms a closed loop through a seam 9. This connection is usually conducted by welding, soldering, and contact bonding.

The method shown in Fig. 2, wherein a block material of a Nb or Nb-Ti is cut into a hollow body, has a poor yield, and further, to improve the magnetic shielding property, pinning centers which prevent a movement of quantized fluxes, i.e., maintain a zero resistivity, for example, a fine precipitate of a normal conductor, or a dislocation network must be distributed in the material. Especially for Nb-Ti, this requires that a cold working be conducted with a high percentage working before and after a heat treatment, under suitable conditions, but it is difficult to subject a block material to cold working with a high percentage working, and the cold working with a high percentage becomes more difficult after the block material is cut into a hollow body. A high percentage working, makes it difficult to prepare a hollow body capable of shielding a large space, from a block material.

To stabilize the superconducting property, it is necessary to dispose a metal having a high conductivity, such as Cu or Al, in a metallically bonded state around the superconducting material, such as Nb or Nb-Ti. Further, preferably the thickness of the superconducting layer is greatly reduced to about 100 µm or less, to stabilize the superconducting property. In the block material, however, a sufficient percentage working cannot be attained because of its large size, and thus a sufficient metallic bond cannot be obtained between the metal having a high conductivity and the superconducting material. Therefore, it is obvious that a formation of a multilayer with a superconducting layer having a thickness of about 100 µm or less is almost impossible.

The technique shown in Fig. 3 is effective when the size of the disk is relatively small. Although the technique has no shielding effect against transverse-fields, an excellent effect can be attained against longitudinal fields, since there is no seam to cause a lowering of the property in a loop through which a superconducting shielding current flows. In this case, it is relatively easy to form a multilayer with a metal having a high conductivity, and further, the thickness of the superconducting layer can be easily reduced to about 100 µm or less by deposition or sputtering. Nevertheless, since the material in the hole provided in the central portion is removed, the yield is poor when the proportion of the hole is high. Further, the size of the disk cannot be increased to more than the size of the plate used as the material. Moreover, a limitation exists in that it is relatively difficult to increase the size of the cylinder in the axial direction.

The technique shown in Fig. 4 provides an excellent yield of the material when preparing a cylinder, and further, facilitates an increase in the size of the cylinder in the axial direction. In this technique, however, a seam must appear, and this causes the superconducting property in the seam to become much lower than in the seamless portion. Bolting is unsatisfactory in the formation of a metallic bond, and welding causes a loss of pinning centers, such as precipitates and dislocations formed in the seamless portion; these bring a remarkable lowering of the property. With respect to soldering, there should exist a contact resistance which decreases the shielding effect.

Further, in the case of a multilayer sheet prepared by alternately laminating a metal having a high conductivity and a superconducting metal, it is almost impossible to conduct a satisfactory seaming. . Another example of a superconducting shield is disclosed in FR-A-2 627 005 and FR-A 2 613 115.

The present invention is intended to solve the above-described problems.

Therefore, an object of the present invention is to provide a superconducting magnetic shield comprising a magnetic shield free of a seam causing a deterioration of a superconducting shield current.

Another object of the present invention is to provide a process for preparing a seamless superconducting shield.

A further object of the present invention is to provide a process for preparing a superconducting magnetic shielding material able to improve the superconducting magnetic shielding property.

A further object of the present invention is to provide a multilayer material comprising a heat-treatable or workable superconducting material and a metal having a high conductivity.

To attain the above-described objects, the present invention is characterized by the constitution of the following superconducting magnetic shield, the process for preparing the shield, and the material of the shield.

Specifically, the superconducting magnetic shield is in the form of a seamless hollow vessel having a bottom, or a seamless hollow body not having a bottom, comprising a sheet or foil composed of alternately laminated layers of at least one layer of an Nb-Ti-base alloy and at least one layer of a metal having a high conductivity.

Further, the metal layer has a high conductivity comprises at least one of copper, an copper alloy, aluminum, and an aluminum alloy, and that a barrier layer of Nb, Ta or a Nb-Ta alloy is provided between the Nb-Ti-base alloy layer and the metal layer having a high conductivity, to prevent interdiffusion and a formation of brittle intermetallic compounds.

Further, a process for preparing a superconducting magnetic shield, comprises press-molding a sheet or a foil composed of alternately laminated layers of at least one layer of a Nb-Ti-base alloy and at least one layer of a metal having a high conductivity, or a sheet or a foil having a diffusion-preventing barrier layer of Nb, Ta or Nb-Ta interposed between the Nb-Ti-base alloy layer and the metal layer having a high conductivity of the above-described sheet or foil, thereby preparing a seamless hollow vessel having a bottom, and optionally cutting the bottom to prepare a bottomless hollow body.

Further, a process for preparing a superconducting magnetic shield, subjects a pillar-like composite comprising alternately and concentrically laminated layers of at least one layer of a Nb-Ti-base alloy and at least one layer of a metal having a high conductivity, or a pillar-like composite having a diffusion-preventing barrier layer of Nb, Ta or Nb-Ta interposed between the Nb-Ti-base alloy layer and the metal layer having a high conductivity of the above-described pillar-like composite, to at least one of tube rolling, extruding and die drawing, to prepare a seamless hollow body not having a bottom.

Further, subsequent to the above-described step, the product is subjected to a heat treatment at 300 to 400°C for 2 to 3000 hr, and then to an optional cold rolling with a percentage working of 2 to 90%.

Further, a process for preparing a superconducting magnetic shield material comprises packing a hollow body having at least one layer of a metal of high conductivity laminated with at least one layer of a barrier layer-coated Nb-Ti-base sheet, to a packing rate of 60% or more, closing the end portion of the hollow body, bringing the inside of the hollow body to a vacuum state for sealing by welding, to prepare an integral composite, subjecting the integral composite to hot working under conditions of a percentage working of 30 to 98% and a temperature of 500 to 1000°C, alternately repeating six times or less a heat treatment under conditions of a temperature of 300 to 450°C and a retention time of 1 to 168 hr per time, and cold working with a percentage working of 30 to 98% per time, to prepare a sheet or a foil, and subjecting the sheet or foil to a final heat treatment under conditions of a temperature of 300 to 450°C and a retention time of 2 to 3000 hr.

Figure 1(a) shows a cylindrical vessel prepared by deep drawing of a sheet shown in Fig. 61;

Fig. 1(b) shows a cylinder prepared by removing the bottom of the cylindrical vessel;

Fig. 2(a) shows a bottomless cylinder prepared by cutting an Nb block;

Fig. 2(b) shows a bottomless tetragonal cylinder prepared by cutting an Nb block;

Fig. 3(a) shows a cylinder prepared by laminating doughnut-like superconducting disks of the same size and having a hole in the center thereof, one on top of the other;

Fig. 3(b) shows a cylinder prepared by alternately laminating the superconducting disk shown in Fig. 3(a) and a normal conducting disk of copper or the like having the same outer diameter and hole diameter as those of the superconducting disk;

Fig. 4(a) shows a superconductor in the form of a tetragonal sheet or foil;

Fig. 4(b) shows a cylinder prepared by bending the sheet or foil shown in Fig. 4(a) and bonding the ends to each other;

Fig. 5 shows a seamless cylindrical superconductor.

All of the above-described superconductors are placed in an external magnetic field parallel to the axis of the hollow body, wherein a superconducting shielding current flows in a direction such that the magnetic field is negated, to thereby produce a magnetic shielding effect. It is also possible to spieled an external field perpendicular to the axis of the hollow body, except in the case of Fig. 3.

Fig. 6 is a cross-sectional perspective view of a Cu/Nb-Ti multilayer composite sheet comprising ten layers of Nb-Ti;

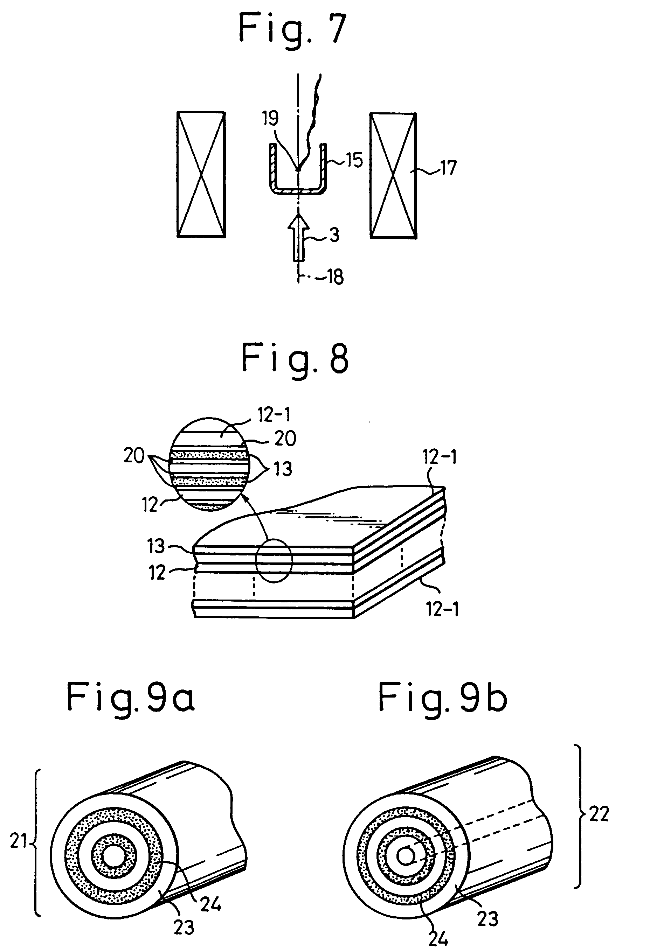

Fig. 7 is a diagram showing the measurement of magnetic shielding effect wherein a cylindrical vessel shown in Fig. 1(a) is set in a bore of a superconducting solenoid magnet, an external magnetic field is applied in parallel to the axis of the cylindrical vessel and a Hall probe is placed inside the vessel;

Fig. 8 is a cross-sectional perspective view of a multilayer composite sheet comprising a Cu/Nb-Ti multilayer composite sheet shown in Fig. 6 and a barrier layer of, e.g., Nb, interposed between the interface of Cu and Nb-Ti.

Fig. 9(a) is a cross-sectional perspective view of a Cu/Nb-Ti multilayer cylindrical composite before tube expanding;

Fig. 9(b) is a cross-sectional perspective view of a multilayer cylindrical composite having a hole in the center thereof, before tube expanding;

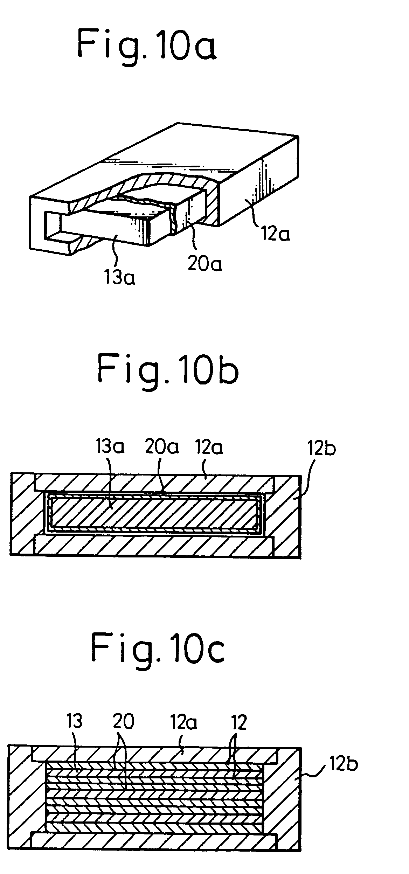

Fig. 10(a) is a diagram showing a hollow body of an oxygen-free copper in a box form having inserted therein one layer of Nb-Ti-base alloy coated several times with an Nb foil;

Fig. 10(b) is a longitudinal cross-sectional view of the composite shown in Fig. 10(a) provided with a lid of oxygen-free copper at both ends thereof;

Fig. 10(c) is a longitudinal cross-sectional view of an composite prepared by fabricating the single layer composite material shown in Fig. 10(a) into thin materials, laminating a plurality of the materials, inserting the resultant laminate in a hollow body of an oxygen-free copper in a box form, and mounting an oxygen-free copper lid at both ends thereof.

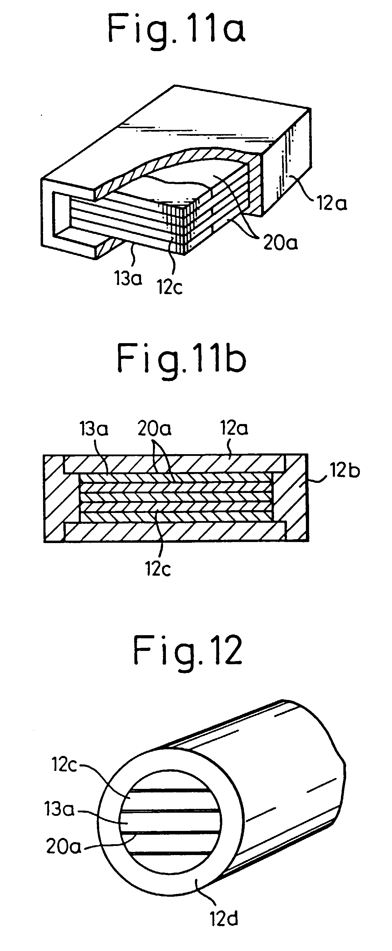

Fig. 11(a) is a diagram showing a hollow body of an oxygen-free copper having inserted therein a laminate of alternate layers of a Nb-Ti-base alloy sheet and an oxygen-free copper sheet;

Fig. 11(b) is a longitudinal cross-sectional view of the integral composite shown in Fig. 11(a) provided with a lid of an oxygen-free copper at both ends thereof;

Fig. 12 is a diagram showing the lamination of an Nb-Ti-base alloy and a metal having a high conductivity in a hollow cylinder;

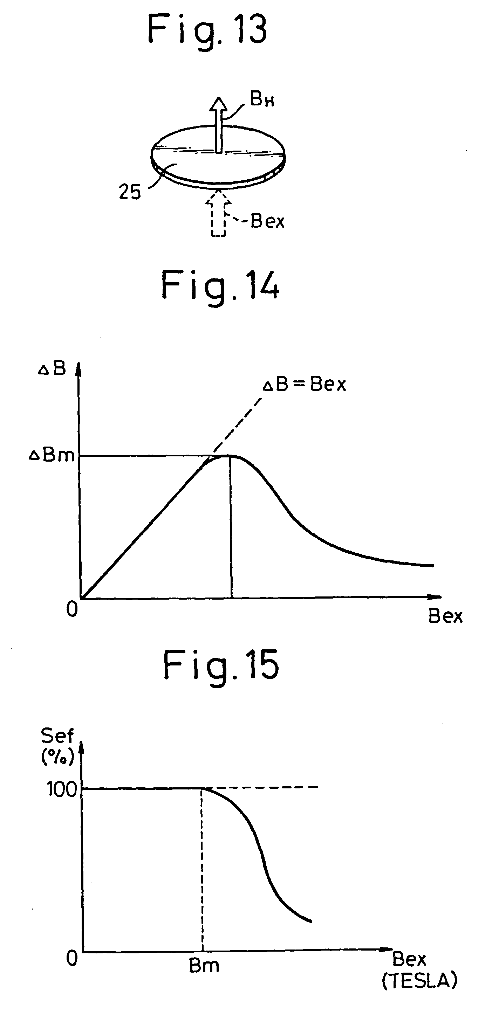

Fig. 13 is a diagram showing the measurement of magnetic shielding effect for a cylindrical volume immediately below the active area of a Hall element. A disk-like sample of a magnetic shielding material is placed in a vertical magnetic field;

Fig. 14 is a graph showing the change in the magnetic shielding property $\Delta B_m$ with an increase in the external magnetic field; and,

Fig. 15 is a graph showing the change in the shielding efficiency with an increase in the external magnetic field $B_{ex}$.

A seamless superconducting magnetic shield in the form of a hollow vessel or a hollow body, as the subject matter of present invention, is prepared by subjecting a multilayer composite sheet comprising a layer of a superconducting alloy, e.g., a Nb-Ti-base alloy, and a metal layer having a high conductivity, e.g., a Cu layer, to pressing, tube rolling, extruding or die drawing.

As shown in Fig. 6, the above-described multilayer composite sheet in a sheet or foil form according to the present invention is prepared by alternately laminating a Cu layer 12 and a Nb-Ti layer 13, disposing a relatively thick Cu layer 12-1 on the upper and lower surfaces, and subjecting the laminate to clad rolling.

The above-described multilayer composite magnetic shielding material exhibits a remarkably improved shielding property compared to the shielding material having the same structure and thickness, but in a single layer.

Such an improvement is attained for the following reason. Specifically, a high magnetic shielding property means high pinning force, and the smaller the thickness per layer, the larger the number of effective pins introduced. Therefore, when the percentage cold working is larger, as in the present invention, it is considered that the precipitation driving force of a precipitate serving as a pin is increased. Further, even when heat is locally generated due to flux jump, the multilayer exhibits an excellent stability due to its high cooling efficiency and high conductivity.

The above-described magnetic shield is prepared by subjecting the above-described multilayer composite sheet to pressing, tube rolling, extruding, die drawing or the like. Since the above-described multilayer composite sheet has an excellent workability, the Nb-Ti-base alloy layer and the metal layer having a high conductivity can be formed into a complete layer structure in the circumferential direction of the hollow body. Accordingly, it becomes possible to prepare a structure free of a remarkably heterogeneous portion over the whole circumference and having an excellent superconducting property, and this enables the problem of the prior art, i.e., the deterioration of the superconducting property due to a heterogeneity of the seam, and consequently, the lowering of the magnetic shielding property, to be solved. There is no limitation of the sectional form of the hollow body, and the sectional form may be circular, polygonal, etc. depending upon the applications of the magnetic shield.

As shown in Fig. 5, in the case of a seamless superconductor in a hollow body form under longitudinal fields, a superconducting shielding current 2 flows in a closed loop in a direction perpendicular to the direction of an external magnetic field Bex (3a) parallel to the axial direction of the hollow body, to form a filed opposite to the external field inside the cylinder. When a seam or a normal conducting portion exists in the course of the closed loop, the superconducting shielding current attenuates with time, and thus the superconducting magnetic shielding effect at the inner space of the cylinder is lost. According to the present invention, the superconducting shielding current can flow over the whole circumference of the hollow body without attenuation, and thus a high magnetic shielding effect can be semipermanently obtained, as long as the shield is super conductive.

The same is basically true in the case where one end of the above-described hollow body is closed with a sheet of the same material, i.e., a hollow vessel having a bottom. In the case of a hollow body having both open ends, a certain amount of a magnetic field generally enters the internal space from the open end in the case of a hollow vessel, having a bottom, the attenuation of external fields is greater than that of a hollow body with both ends open. Therefore, when the magnetic shielding is conducted by means of a hollow body having a relatively small length in the axial direction thereof, with higher efficiency, a hollow body having a bottom is suitable.

Further, to shield a stronger magnetic field, it is also possible to increase the thickness of the hollow vessel or a bottomless hollow body in such a manner that a plurality of hollow vessels or bottomless hollow bodies having similar shapes but slightly different sizes are provided, and these are placed concentrically one on top of the other.

In Fig. 5, the space in the inside of the hollow body is shielded against an external magnetic field from the outside of the hollow body. It is naturally possible for an object capable of generating the magnetic field, such as superconducting coil to be provided within the hollow body and the external space shielded against the magnetic field from the inside of the hollow body.

In the above-described embodiments, the superconductor is disposed in such a manner that the central axis of the hollow vessel or hollow body is parallel to the direction of the external magnetic field or internal magnetic field. It is also possible to conduct a magnetic shielding even when the central axis is perpendicular to the external or internal magnetic field or tilted at an angle of between 0° and 90° to the external or internal magnetic field.

The metal layer having a high conductivity plays an important role in the stabilizing of the superconducting property, and copper or aluminum having a small resistance is must preferable as the metal. These metals, however, have a considerably lower strength than that of the Nb-Ti-base alloy. To improve the workability of these metals in a composite form, it is also possible to add other elements in a small amount such that no significant lowering of the conductivity occurs. Further, the metal may be a copper alloy comprising Cu, and added thereto at least one of Ag, Zn, Sn, Ni, Si, P, Mn, Zr, Cr and Al, or an aluminum alloy comprising Al, and added thereto at least one of Ag, Sn, Sn, Ni, Si, P, Mn, Zr, Cr and Cu.

To obtain the above-described high superconducting magnetic shielding property, the pinning centers which pin the magnetic flux lines must be substantially homogeneously distributed within the Nb-Ti-base alloy layer at an appropriate density. Examples of the pinning centers in Nb-Ti alloy include dislocations and lattice defects, etc., introduced by cold working, and $\alpha$-Ti precipitate produced by heat treatment. It has been confirmed that the $\alpha$-Ti precipitate is very effective even in the case of a magnetic shielding by a sheet or a foil. This precipitate is an aging precipitate formed by heat treatment over a relatively long time. Therefore, in the case of a Cu/Nb-Ti multilayer composite sheet, different metals are diffused into each other at the interfaces thereof to form a hard, brittle Cu-Ti inter metallic compound. This causes the component ratio of the Nb-Ti-base alloy layer to change, and thus problems arise such as a deterioration of the superconducting property and the impossibility of subsequent working.

In this case, the provision of a barrier comprising a Nb, Ta or Nb-Ta alloy at the interface of Cu and Nb-Ti, to prevent diffusion, enables the above-described problems to be substantially completely solved. For example, a multilayer composite sheet can be prepared by laminating an Nb-Ti-base alloy sheet and a metal sheet having a high conductivity, each having a suitable thickness, while sandwiching an Nb foil between the alloy sheet and the metal sheet, hermetically sealing the laminate within a box made of a metal sheet having a high conductivity, and subjecting the assembly to rolling, etc.

Besides the Nb-Ti binary alloy, ternary or higher alloys comprising Nb-Ti, and added thereto at least one of Ta, Hf, V and Zr, also may be used as the Nb-Ti-base alloy.

A multilayer composite sheet comprising alternately laminated layers of a Nb-Ti-base alloy layer and a metal layer having a high conductivity is prepared, and the composite sheet is pressed to prepare a seamless hollow vessel or bottomless hollow body. Examples of the pressing include deep drawing, overhanging, forging and extruding. In the deep drawing, it is also possible to conduct shear deep drawing, re-deep drawing and a repetition thereof, to increase the length of the axial direction of the hollow vessel. Further, a stronger working may be conducted through the use of a combination with hydraulic forming or the adoption of spinning molding wherein use is made of a roll. The same is true where a barrier comprising Nb, Ta or a Nb-Ta alloy is disposed between the Nb-Ti-base alloy layer and the metal layer having a high conductivity. There is no limitation of the sectional form, which may be circular or polygonal.

In Fig. 9(a), a pillar-like composite comprising alternately and concentrically laminated layers of at least one Nb-Ti-base alloy layer and at least one metal layer having a high conductivity is prepared, and the composite is subjected to tube rolling, extruding, and die drawing, etc., to prepare a cylinder wherein individual layers are metallically bonded to each other. As shown in Fig. 9(b), a hole may be provided from the beginning at the center of the core member, i. e., working also may be started from a cylindrical composite. In this case, the outermost member and the core member may be either a Nb-Ti-base alloy or a metal having a high conductivity; although the metal having a high conductivity is preferable when the lubricity during working and the stability of the superconductor are taken into consideration. The Nb-Ti-base alloy layer and the metal layer having a high conductivity can be provided in such a manner that a concentrically complete layer structure is maintained in the circumferential direction of the cylinder. The same is true where a barrier comprising Nb, Ta or a Nb-Ta alloy is provided between the Nb-Ti-base alloy layer and the metal layer having a high conductivity. The section of the pillar-like composite or cylindrical composite may be in a polygonal form, such as tetragonal form, besides the above-described circular form. The same is true of the final sectional form after the tube expanding. These working methods are advantageous over the above-described pressing in that a longer and narrower product can be prepared. Examples of the tube rolling include mannesmann piercing and stiefel piercing, examples of the extruding include the Erhardt method, and examples of the die drawing include sinking, mandrel drawing and plug drawing.

The hollow vessel or bottomless hollow body is heat treated under conditions of a temperature of 300 to 450°C and a retention time of 2 to 3000 hr. This causes the above-described $\alpha$-Ti precipitate serving as a pinning center indispensable to an improvement of the magnetic shielding property. The heat treatment temperature is limited to 300 to 450°C, for the following reason. When the temperature is below 300°C, a longer retention time becomes necessary, and thus the production cost is high. On the other hand, when the temperature exceeds 450°C, the precipitate grows to a large size, which makes it impossible to improve the shielding property, regardless of the retention time. The retention time is limited from 2 to 3000 hr, for the following reason. When the retention time is shorter than 2 hr, the precipitate cannot be sufficiently formed. On the other hand, when the retention time exceeds 3000 hr, the precipitation is saturated, and thus no further effect can be attained and the production cost is high.

The above-described heat treatment may be conducted before molding into a hollow vessel or a bottomless hollow body. The precipitate in this case, however, lowers the workability, and it becomes impossible to conduct a heat treatment capable of remarkably improving the magnetic shielding property as intended in the present invention. Accordingly, the heat treatment is conducted after molding.

The reason why a slight cold working is conducted after the above-described heat treatment is that the dislocations introduced at that time intertwine with the already formed precipitates to further improve the pinning force. The percentage working is limited to 2 to 90%. When the percentage working is less than 2%, no improvement in the property is attained, due to an insufficient working effect. On the other hand, when the percentage working exceeds 90%, the property is lowered due to an excessive breakage of the precipitate, and the material is broken during working.

The above-described multilayer composite sheet comprising alternately laminated layers of an Nb-Ti-base alloy layer and a metal layer having a high conductivity is preferably prepared by a clad rolling process disclosed in Japanese Unexamined Patent Publication No. 2-94498, previously filed by the present inventors, i.e., a process which comprises packing a hollow body in a box or cylindrical form comprising a metal having a high conductivity with at least one layer of an Nb or Ta foil-coated Nb-Ti-base alloy sheet in such a manner that the Nb-Ti-base alloy sheet and the above-described metal having a high conductivity are alternately laminated to a percentage packing of 60% or more, closing the end of the hollow body with the above-described metal having a high conductivity, bringing the inside of the hollow body to a vacuum state for sealing by welding, to prepare an integral composite, subjecting the integral composite to hot working under conditions of a percentage working of 30 to 98% and a temperature of 500 to 1000°C, alternately repeating six times or less a heat treatment under conditions of a temperature of 300 to 450°C and a retention time of 1 to 168 hr per time and cold working with a percentage working of 30 to 98% per time to prepare a sheet or a foil to obtain a multilayer composite in a sheet or foil form.

In the preparation of the above-described multilayer composite, a final heat treatment under conditions of a temperature of 300 to 450°C and a retention time of 2 to 3000 hr after the above-described cold working enables a further improved magnetic shielding property and workability to be imparted.

In the above-described hot working, cold working and final heat treatment, when a barrier layer, e.g., Nb or Ta layer 20, is provided at all of the interfaces of the Nb-Ti-base alloy layer 13 and the metal layer 12 having high conductivity, the subsequent working can be conducted more easily.

Specifically, when a heat treatment is conducted at a temperature capable of forming a Cu-Ti or Al-Ti compound for a considerably high temperature as in the case where the above-described heat treatment is conducted, the formation of this compound deteriorates the workability to a considerable extent. In this case, when the above-described barrier layer 20 is present between both the above-described layers, it becomes possible to substantially prevent the diffusion of the metal elements between both the layers during the heat treatment. Therefore, in the magnetic shielding material according to the present invention, high magnetic shielding property can be attained while maintaining a good workability. Due to this excellent workability, the thickness of the shielding material can be reduced to the order of several tens μm, so that not only can the weight of the shielding material be reduced but also the material cost per unit area of the shielding material can be lowered.

An embodiment of a process for preparing the magnetic shielding material having the above-described barrier layer shown in Fig. 8 is shown in Figs. 10(a) to (c). In Fig. 10(a), an Nb-Ti-base alloy sheet 13a coated with a foil 20a as a barrier over the whole surface is inserted in a relatively thick hollow body in a box form made of a metal having a high conductivity to a percentage packing of 60% or more, both ends of the above-described hollow body 12a are covered with a lid 12b, as shown in Fig. 10(b), the inside of the hollow body is brought to a vacuum state, hermetical sealing is conducted by electron beam welding or the like, and hot working, cold working, and heat treatment, etc. are then conducted. Thus, a good metallic adhesion is attained between individual members without internal oxidation, and a single layer composite having a good workability can be prepared. The reason why the percentage packing is limited to 60% or more is as follows. When the percentage packing is less than 60%, a distortion occurs in each member at an early stage of the working, which causes the material to be broken due to a deterioration of the adhesion.

As shown in Fig. 10(c), a plurality of the magnetic shielding materials in a thin sheet form thus prepared are laminated, hermetically sealed with the hollow body 12a and the lid 12b, and further subjected to working and heat treatment to prepare a multilayer magnetic shielding material as shown in Fig. 8 wherein the upper and lower surfaces are covered with a relatively thick metal layer 12-1 having high conductivity.

Another embodiment of the process for preparing the above-described magnetic shielding material is shown in Figs. 11(a) and (b). In Fig. 11(a), a Nb-Ti-base alloy sheet 13a coated with a barrier layer 20a and a metal sheet 12c having a high conductivity are alternately laminated in the above-described hollow body 12a. The hollow body is then closed with a lid 12a as shown in Fig. 11(b), and the hermetical sealing, working, and heat treatment are conducted in the same manner as in the case shown in Fig. 10. The above-described process is advantageous in that the volume percentage of both metal sheets can be freely selected, a multilayer structure can be easily formed, and the number of layers can be freely increased.

A multilayer magnetic shielding material shown in Fig. 8 can be prepared in the case of a cylindrical hollow body 12d shown in Fig. 12, besides a hollow body 12a in a box form shown in Figs. 10 and 11.

The above-described steps are conducted to prepare the above-described magnetic shielding material. In this case, the reason why the above-described integral composite is subjected to hot working before the heat treatment and cold working is that, after the composite is heated to some extent to soften each member, they are subjected to contact bonding by rolling, forging, and extruding, etc., to attain a good metallic adhesion. The hot working temperature is limited to 500 to 1000°C for the following reason. When the temperature is below 500°C, a sufficient adhesion is not attained because each member, particularly an Nb-Ti-base alloy having a high softening temperature, is still hard. On the other hand, when the temperature exceeds 1000°C, the temperature becomes close to the melting point of copper, among the metals having a high conductivity, which causes the nonconformity of the hardness between the metal having a high conductivity and the Nb-Ti-base alloy to become large, so that the adhesion lowers. When aluminum having a melting point as low as 660°C is used, however, it is obvious that the hot working can be conducted at a temperature below the melting point. The percentage working in this case is limited to 30 to 98% for the following reason. When the percentage working is less than 30%, a sufficient adhesion is not attained even when the temperature is high. On the other hand, when the percentage working exceeds 98%, the percentage cold working necessary for an improvement in the magnetic shielding property cannot be attained.

The heat treatment temperature is limited to 300 to 450°C. When the temperature is below 300°C, the precipitation rate of the $\alpha$-Ti fine particle serving as an important pinning center is so small that much time is needed for precipitation. On the other hand, when the temperature exceeds 450°C, the precipitated particle grows to a large size, so that the magnetic shielding property is unfavorably lowered. The retention time per time is limited to 1 to 168 hr. When the retention time is less than 1 hr, the absolute quantity of the precipitation is insufficient. On the other hand, when the retention time exceeds 168 hr, the precipitation is substantially saturated, so that a significant effect can be not attained even when the retention time is further increased.

Lattice defects, such as dislocations introduced by cold working and vacancies, become the driving force of the precipitation. A further improved effect can be attained when cold working is conducted to some extent before heat treatment. Alternate repetition of cold working and heat treatment brings a further improved effect. The number of repetitions is limited to 6 times or less. When the number of repetitions exceeds six, the cold working between individual heat treatments cannot be conducted with a sufficiently high percentage cold working, so that the maximum effect is reached.

Further, when the heat treatment and the cold rolling are alternately conducted in a plurality of number of times, the percentage cold working per time between individual heat treatments or up to a formation of a final shape is limited to 30 to 98%. When the percentage cold working is less than 30%, the amount of lattice defects introduced is insufficient, so that the effect of the heat treatment cannot be utilized. On the other hand, when the percentage working per time exceeds 98%, part or the whole of the material is broken, which brings a failure in working or an excessive increase in the thickness at the beginning of working, so that it becomes impossible to actually produce a superconducting shielding material.

The reason why the final heat treatment is conducted after cold working to a final sheet thickness is that the $\alpha$-Ti

particle precipitate effective as a pinning center in the magnetic field wherein the magnetic shielding is conducted is formed, and a synergistic effect can be attained by the formed $\alpha$-Ti particle precipitate and the precipitate formed by the above-described heat treatment and subjected to working. The reason why the heat treatment temperature is limited to 300 to 450°C is the same as in the case of the above-described heat treatment. The retention time is limited to 2 to 3000 hr. When the retention time is less than 2 hr, the absolute quantity of the precipitate is insufficient. On the other hand, when the retention time exceeds 3000 hr, the precipitation is substantially saturated, so that a significant effect cannot be attained even when the heat treatment is conducted for longer than 3000 hr.

When the sheet or foil subjected to the above-described final treatment is further subjected to cold working with a percentage working of 2 to 30% exclusive, an improvement in the magnetic shielding property is observed over the material subjected to the final heat treatment only. When the percentage working is less than 2%, a sufficient cold working effect is not attained. On the other hand, when the percentage working is 30% or more, the amount exceeds an optimal range and the magnetic shielding property is remarkably lowered.

The $\Delta B$ value was determined as shown in Fig. 13. Specifically, a magnetic shielding sample 25 was set in an external magnetic field $B_{ex}$ (a magnetic field in the absence of the sample) perpendicularly to the sample 25. The magnetic field $B_H$ with the sample 25 set in place was measured by a Hall probe, and the $\Delta B$ value was determined according to the following equation:

$$\Delta B = B_{ex} - B_H$$

A general relationship between the above-described $B_{ex}$ and $\Delta B$ is shown in Fig. 14, so that the percentage increase of the $\Delta B$ value begins to decrease and the $\Delta B$ value reaches the maximum value $\Delta Bm$ and then gradually decreases. Accordingly, the $S_{eff}$ value determined by the following equation was defined as a shielding efficiency:

$$S_{eff} = 100 \text{ x } \Delta B/B_{ex} \text{ (%)}$$

In the present specification, in particular, the $S_{eff}$ value when the $B_{ex}$ value was 0.5 Tesla was used as an index for evaluation of magnetic shielding property.

The relationship between the above-described shielding efficiency, $S_{eff}$, and the $B_{ex}$ value is shown in Fig. 15. The $S_{eff}$ value maintained about 100% until the $B_{ex}$ value reached a certain value but began to rapidly decrease as the $B_{ex}$ increased. It is also possible for the maximum $B_{ex}$ value $B_m$ until the $S_{eff}$ value can be maintained at about 100% to be used as an index for evaluation of the magnetic shielding property.

As described above, when the final heat treatment is conducted, the workability, particularly the deep drawing workability, improves, but when the deep ratio (depth/diameter) of the deep drawing is large, it becomes necessary to repeat the step of deep drawing a plurality of times. In this case, it is also possible to improve the workability through a further heat treatment between the steps of the deep drawing.

Thus, when the material is subjected to deep drawing and then a heat treatment at 300 to 450°C, the dislocations and defects introduced by distortion caused during working become a driving force for a new precipitation, which enables the magnetic shielding property to be further improved.

EXAMPLE

Example 1

As shown in Fig. 6, a 0.77 mm-thick Cu/Nb-Ti multilayer composite sheet 14 comprising alternately laminated layers of nine Cu layers 12 each having a thickness of 30 mm and ten Nb-Ti 13 layers and a 100 $\mu$m-thick Cu layer 12-1 provided on both outermost surfaces was prepared by the clad rolling disclosed in the present invention. The multilayer composite 14 thus prepared was formed into a circular blank having a diameter of 70 mm, and deep drawing was conducted through the use of a punch having an outer diameter of 25 mm and a die having an inner diameter of 27.2 mm. Thus, a cylindrical vessel 15 as shown in Fig. 1(a) having an inner diameter of 25 mm, a wall thickness of 0.77 mm and a height of about 30 mm was prepared. The workability was excellent, and neither breakage or defects occurred in the course of the preparation of the cylindrical vessel.

Then, as shown in Fig. 7, the above-described cylindrical vessel 15 was placed in the bore of a solenoid type superconducting coil 17, in such a manner that the central axis 18 of the cylindrical vessel and the magnetic field 3 produced by the coil were parallel to each other. Further, a Hall probe 19 having a diameter of 5 mm was set in the center portion of the vessel, and the whole was immersed in a liquid helium to examine the magnetic shielding property.

In this measurement, an excellent magnetic shielding property was obtained. Specifically, the shielding efficiency was almost 100% until the strength of the magnetic field produced by the coil reached 0.21 Tesla, and no attenuation of the property was observed for a measurable time.

The same level of results were obtained with respect to samples wherein use was made of aluminum, various copper alloys, and aluminum alloy instead of copper.

For comparison, cylindrical samples indicated by numeral 1 of Fig. 2, numeral 7 of Fig. 3 and numeral 10 of Fig. 4 were subjected to the test in the same manner as that described above. The total thickness of the Nb-Ti layer of these samples and various sizes of the cylinder were made the same as those of sample 15 shown in Fig. 7, as much as possible. As a result, sample 1 shown in Fig. 2 exhibited a remarkable lowering in the magnetic shielding property in the magnetic field having a strength of about one-tenths of that in the case of the product of the present invention. Pressure welding and soldering, etc., were attempted on the sample 10 shown in Fig. 4, but because of the electrical resistance at a seam, the magnetic shielding effect was attenuated and disappeared for a very short time. With respect to sample 7 shown in Fig. 3, the magnetic shielding property was on the same level as that of the sample of the present invention, but since the area proportion of the central hole was very large and the material for that portion was removed, the yield of the material was very low.

## Example 2

A cylindrical vessel 15 was prepared in the same manner as that of Example 1. The bottom portion of the vessel was cut to prepare a cylindrical sample 11 shown in Fig. 5, and the sample 11 was subjected to measurement of the magnetic shielding property. As a result, substantially the same level of high magnetic shielding property as that of the product of the present invention described in Example 1 was obtained, although a slight lowering in the magnetic shielding property was observed due to a greater penetration of the magnetic field from both ends. Similarly, no attenuation was detected.

## Example 3

A Cu/Nb-Ti multilayer composite sheet as shown in Fig. 8 was prepared in the same manner as that of Example 1, except that a 1 $\mu$m-thick Nb barrier layer 20 was provided in all of the interfaces of the copper layer and the Nb-Ti layer, and the thickness of the whole sheet was 0.79 mm. Deep drawing was conducted in the same manner as that of Example 1. As a result, the workability was substantially the same as that of the sample of Example 1. The sample was subjected to measurement of the magnetic shielding property. As a result, a diffusion preventing effect by the barrier could be obtained particularly under heat treatment conditions of a long retention time used in Nos. 1 to 3 and No. 5 shown in Table 1, and the property was superior by 10 to 50% to the sample of Example 1 subjected to the same heat treatment. A cylinder after removal of the bottom exhibited a magnetic shielding property similar to that of Example 2. The same results were obtained when a Ta barrier or a Nb-Ta alloy barrier was used instead of the Nb barrier.

## Example 4

As shown in Fig. 9(a), an Nb-Ti tube and a copper tube each having a wall thickness of 5.5 mm were alternately laminated in a copper tube having an outer diameter of 60 mm and an inner diameter of 48 mm, a copper rod having a diameter of 12 mm was inserted into the center of the tube, both ends thereof were closed with a copper lid, and the resultant composite was subjected to electron beam welding in vacuum and then subjected to tube expanding while making a hole in the center thereof by hot tube expanding or hot extruding, to thereby prepare a cylinder. Further, the cylinder was subjected to die drawing to prepare a cylinder having an outer diameter of 30 mm and a wall thickness of 2 mm, cut to a length of 30 mm to prepare a cylinder as shown in Fig. 1(b) and subjected to measurement of the magnetic shielding property in the same manner as that of Example 2. As a result, substantially the same level of magnetic shielding property was obtained.

The same level of magnetic shielding property was obtained in the case of a cylinder as shown in Fig. 9(b) having the same structure as that described above, except that the diameter of the center hole was 12 mm and the wall thickness of each tube was 4.5 mm. Further, the same level of magnetic shielding property was obtained in the case of a cylinder prepared by alternately and concentrically laminating tetragonal Nb-Ti tube and copper tube in a tetragonal copper tube and subjecting the resultant composite to the same working as that described above. Further, the same level of magnetic shielding property was obtained when an Nb foil was sandwiched between individual laminated tubes. Further, the same level of magnetic shielding property was obtained when a Ta foil or a Nb-Ta alloy foil was used instead of the Nb foil. Furthermore, the same level of magnetic shielding property was obtained when the final sectional form was tetragonal.

## Example 5

A cylindrical sample 11 as shown in Fig. 5 was prepared in the same manner as that of Example 3, heat-treated under conditions shown in Table 1, and then subjected to the measurement of the magnetic shielding property in the same manner as that of Example 1. In this case, the magnetic shielding property was evaluated based on the maximum

value $B_m$ determined from the value, $B_{ex}$, of the external magnetic field and the value, $B_H$, of the magnetic field detected by a Hall probe. The results are shown in Table 1.

Table 1

| No. | Type | Heat treatment temp. (°C) | Retention time (hr) | $B_m$ (Tesla) |
|---|---|---|---|---|
| 1 | present invention | 310 | 2500 | 0.58 |
| 2 | present invention | 350 | 1000 | 0.73 |
| 3 | present invention | 350 | 100 | 0.41 |
| 4 | present invention | 440 | 3 | 0.32 |
| 5 | comparative | 290 | 3100 | 0.21 |
| 6 | comparative | 460 | 1 | 0.12 |

Example 6

A cylindrical sample was prepared in the same manner as that of Example 3, heat-treated under conditions shown in Table 2, subjected to cold tube expanding or die drawing with a percentage working shown in Table 2, and the magnetic shielding property evaluated in the same manner as that of Example 3. The percentage increase (%) of Bm value of a sample subjected to cold working relative to a sample as heat-treated was used as an index for the evaluation. The results are shown in Table 2.

Percentage increase of $B_m$ (%) = 100 x (Bm after cold rolling/Bm after heat treatment - 1)

Table 2

| No. | Type | Heat treatment temp. (°C) | Retention time time (hr) | Percentage cold working (%) | Percentage increase of Bm (%) |
|---|---|---|---|---|---|
| 1 | present invention | 350 | 1000 | 3 | 8 |
| 2 | present invention | 350 | 1000 | 40 | 38 |
| 3 | present invention | 350 | 1000 | 85 | 15 |
| 4 | comparative | 350 | 1000 | 1 | 0 |
| 5 | comparative | 350 | 1000 | 93 | -34 |

Example 7

As shown in Fig. 11(a), seven sheets 13a of a Nb-46 wt.% Ti alloy having a thickness of 5 mm, a width of 100 mm, and a length of 150 mm, and coated several times with an Nb foil 20a having a thickness of 0.1 mm and six sheets 12c of oxygen-free copper having the same size as that of the alloy sheet except that the thickness was 2 mm, were inserted into a hollow body 12a in a box form made of oxygen-free copper having an outer size of 58 mm in thickness, 112 mm in width, and 172 mm in length, and an inner size of 50 mm in thickness, 102 mm in width, and 172 mm in length. As shown in Fig. 11(b), both ends of the hollow body 12a were closed with a lid 12b having a size conforming to the hollow portion, and the parting lines were welded while conducting vacuum drawing for hermetical sealing, thereby preparing an integral composite. The integral composite was heated at a temperature of 750°C, hot-rolled to a thickness of 27 mm, subjected to cold rolling and heat treatment under conditions shown in Table 3 to prepare a disk sample having a thickness of 0.1 mm and a diameter of 50 mm, and subjected to measurement of the magnetic shielding property. In the measurement, the $S_{eff}$ value when the $B_{ex}$ value was 0.5 Tesla was determined as an index for evaluation of the magnetic shielding property.

The percentage intermediate working shown in Table 3 is a percentage working in the working conducted between a certain heat treatment and a subsequent heat treatment, and the percentage final working is a percentage working conducted immediately before the final heat treatment.

In Nos. 1 to 12, the shielding property was determined under constant conditions of the percentage intermediate working, final percentage working, and final heat treatment with varied intermediate heat treatment conditions and number of repetitions. Note, the intermediate working was not conducted on Nos. 1 and 10, wherein the number of repetitions was one. In Nos. 1 to 5, an improvement in the magnetic shielding property was observed by considerably prolonging the retention time (No. 1) when the heat treatment temperature was relatively low and by shortening the retention time and increasing the number of repetitions when the heat treatment temperature was high (Nos. 2 to 5). In particular, a high characteristic value was obtained under conditions of Nos. 2 and 3.

Nos. 6 to 12 are the same as Nos. 1 to 5, except that in each material, one of three conditions of the intermediate heat treatment temperature, retention time, and number of repetitions was changed. None of these cases satisfied the requirement of the present invention, and the magnetic shielding property was very poor. Among them, No. 11 became impossible to work in the course of final working, due to breaking of the material.

EP 0 424 835 B1

### Table 3

| No. | Classification | Intermediate heat treatment temp. (°C) | Retention time of intermediate heat treatment (hr) | Number of repetitions | Percentage intermediate working (%) | Percentage final working (%) | Final heat treatment temp. (°C) | Retention time of final heat treatment (hr) | $S_{eff}$ (%) at 0.5 T |
|---|---|---|---|---|---|---|---|---|---|
| 1 | Ex. | 310 | 160 | 1 | - | 70 | 360 | 200 | 40 |
| 2 | " | 360 | 40 | 3 | 50 | 70 | 360 | 200 | 80 |
| 3 | " | 360 | 20 | 5 | 50 | 70 | 360 | 200 | 80 |
| 4 | " | 360 | 15 | 6 | 50 | 70 | 360 | 200 | 70 |
| 5 | " | 440 | 2 | 6 | 50 | 70 | 360 | 200 | 50 |
| 6 | Comp. Ex. | 290 | 160 | 1 | 50 | 70 | 360 | 200 | 2 |
| 7 | " | 460 | 2 | 6 | 50 | 70 | 360 | 200 | 8 |
| 8 | " | 360 | 0.5 | 6 | 50 | 70 | 360 | 200 | 1 |
| 9 | " | 440 | 0.5 | 6 | 50 | 70 | 360 | 200 | 1 |
| 10 | " | 310 | 180 | 1 | - | 70 | 360 | 200 | 8 |
| 11 | " | 360 | 15 | 7 | 50 | impossible to work | - | - | - |
| 12 | " | 360 | 10 | 7 | 50 | 70 | 360 | 200 | 23 |
| 13 | Ex. | 360 | 40 | 3 | 35 | 70 | 360 | 200 | 58 |
| 14 | " | 360 | 40 | 2 | 96 | 70 | 360 | 200 | 42 |
| 15 | Comp. Ex. | 360 | 40 | 2 | 99 | impossible to work | - | - | - |
| 16 | Ex. | 360 | 40 | 3 | 50 | 35 | 360 | 200 | 40 |
| 17 | " | 360 | 40 | 3 | 50 | 96 | 360 | 200 | 70 |
| 18 | Comp. Ex. | 360 | 40 | 3 | 50 | 25 | 360 | 200 | 6 |
| 19 | " | 360 | 40 | 3 | 50 | 70 | 290 | 200 | 12 |
| 20 | " | 360 | 40 | 3 | 50 | 70 | 460 | 200 | 5 |
| 21 | " | 360 | 40 | 3 | 50 | 70 | 360 | 1 | 1 |
| 22 | Ex. | 360 | 40 | 3 | 50 | 70 | 360 | 1500 | 64 |
| 23 | " | 360 | 40 | 3 | 50 | 70 | 360 | 2500 | 85 |
| 24 | Comp. Ex. | 360 | 40 | 3 | 50 | 70 | 360 | 3100 | 70 |

Nos. 13 and 14 were treated under the same conduction as that of No. 2, except that the number of repetitions of intermediate heat treatment and the percentage intermediate working were changed. In Nos. 13 and 14, the percentage intermediate working was close to the upper limit, and the magnetic shielding property thereof was not as good as that of No. 2.

No. 15 was the same as No. 14, except that only the percentage intermediate working was further increased to 99%. With No. 15, it became impossible to conduct working in the course of the final working, due to breaking of the material.

Nos. 16 and 17 were the same as No. 2, except for the percentage final working. The percentage working was close to the upper limit, and the property of No. 16 was not as good as that of No. 2. The property of No. 17 was considerably superior to that of No. 16 but slightly inferior to that of No. 2.

No. 18 was the same as No. 16, except that only the percentage intermediate working was further reduced to 25%. No. 18 brought about a remarkable lowering in the property.

Nos. 19 to 21 were the same as No. 2, except that one of two conditions of the final heat treatment temperature and the retention time was varied. None of these cases satisfied the requirement of the present invention, and the magnetic shielding property was very poor.

Nos. 22 and 23 were the same as No. 2, except that only the retention time of the final heat treatment was varied. In No. 22, a considerable improvement in the property was observed due to a prolonging of the retention time to 500 hr. In No. 23, the heat treatment time was close to the upper limit, and the property was lowered.

No. 24 was the same as No. 23, except that the retention time was further prolonged by 100 hr. This brought about a further remarkable lowering in the property.

As described above, according to the present invention, a seamless hollow vessel or a seamless, bottomless hollow body can be prepared which comprises a Cu/Nb-Ti multi layer composite sheet or a Cu/Nb or Ta barrier/Nb-Ti multilayer composite sheet. Therefore, it becomes possible to flow a large superconducting shielding current in the circumferential direction of the hollow body, which enables a stable high magnetic shielding property to be obtained as long as the hollow body is in a superconducting state.

Further, a suitable treatment or suitable treatment and cold working following molding of the material into a hollow vessel or a bottomless hollow body can remarkably improve the magnetic shielding property, compared to that of a product not subjected to this working, and thus the present invention is very useful from the viewpoint of industry.

## Claims

1. A superconducting magnetic shield comprising a seamless hollow body having a wall comprised of, in a thickness direction thereof, more than two laminate structures each laminate structure comprising an Nb-Ti-base alloy layer (13) and a metal layer (12) having a high conductivity.

2. A superconducting magnetic shield comprising a seamless hollow body having a wall comprised of, in a thickness direction thereof, a laminate structure comprising one or more Nb-Ti-base alloy layers (13) having a mixed microstructure of cold-worked one and $\alpha$-Ti precipitated one, and one or more metal layers (12) having a high conductivity with each interface metallically bonded.

3. A magnetic shield according to claim 1 or 2, wherein one opening of said hollow body is closed with a bottom comprising said laminate structure.

4. A magnetic shield according to any of claims 1 to 3, wherein a barrier layer (20) is inserted between said Nb-Ti-base alloy layer (13) and said metal layer (12).

5. A magnetic shield according to any of claims 1 to 4, wherein the innermost layer member and the outermost layer member each comprise a metal layer (12) having a high conductivity.

6. A magnetic shield according to any of claims 1 to 5, wherein the metal layer (12) having a high conductivity comprises any one of copper, copper alloys, aluminum and aluminum alloys.

7. A magnetic shield according to claim 6, wherein the copper alloy comprises copper having added thereto at least one member selected from the group consisting of Ag, Zn, Sn, Ni, Si, P, Mn, Zr, Cr and Al.

8. A magnetic shield according to claim 6, wherein the aluminum alloy comprises aluminum having added thereto at least one member selected from the group consisting of Ag, Zn, Sn, Ni, Si, P, Mn, Zr, Cr and Cu.

9. A magnetic shield according to any of claims 1 to 8, wherein said barrier layer (20) comprises Nb, Ta or a Nb-Ta alloy.

10. A magnetic shield according to any of claims 1 to 9, wherein a plurality of said hollow bodies having a different outer diameter and inner diameter are placed one on top of the other to form a hollow body having a large wall thickness.

11. A process for preparing a superconducting magnetic shield which comprises subjecting a sheet or foil comprising a laminate structure comprised of an Nb-Ti-base alloy layer (13) and a metal layer (12) having a high conductivity to pressing, to form a seamless hollow vessel having a bottom.

12. A process according to claim 11, wherein said laminate structure is comprised of an Nb-Ti-base alloy layer, a barrier layer and a metal layer having a high conductivity.

13. A process according to claim 11 or 12, wherein the bottom of said hollow vessel is cut to form a bottomless hollow body.

14. A process for preparing a superconducting shield which comprises subjecting a pillar-like composite comprising a concentric laminate of a laminate structure composed of an Nb-Ti-base alloy layer (13), and a metal layer (12) having a high conductivity to at least one of tube rolling, extruding and die drawing to form a seamless hollow body.

15. A process according to claim 14, wherein a barrier layer (20) is inserted between said Nb-Ti-base alloy layer (13) and said metal layer (12) having a high conductivity.

16. A process according to any of claims 11 to 15, wherein said superconducting magnetic shield is heated under conditions of a temperature of 300 to 450°C and a retention time of 2 to 3000 hr.

17. A process according to claim 16, wherein subsequent to said heat treatment, said superconducting magnetic shield is subjected to cold working with a percentage working of 2 to 90%.

18. . A process for preparing a superconducting magnetic shielding material which comprises packing a hollow body having at least one metal layer of high conductivity laminated with at least one layer of a barrier layer-coated Nb-Ti-base alloy sheet to a packing rate of 60% or more, closing the end portion of the hollow body, bringing the inside of the hollow body to a vacuum state for sealing by welding to prepare a integral composite, subjecting the integral composite to hot working under conditions of a percentage working of 30 to 98% and a temperature of 500 to 1000°C, alternately repeating six times or less a heat treatment under conditions of a temperature of 300 to 450°C and a retention time of 1 to 168 hr per time and cold working with a percentage working of 30 to 98% per time, to prepare a sheet or a foil, and subjecting the sheet or foil to a final heat treatment under conditions of a temperature of 300 to 450°C and a retention time of 2 to 3000 hr.

19. A process according to claim 18 wherein, subsequent to said final heat treatment, said sheet or foil is subjected to cold working with a percentage working of 2 to 30% exclusive.

**Patentansprüche**

1. Supraleitende magnetische Abschirmung mit einem nahtlosen Hohlkörper mit einer Wand, die in Richtung ihrer Dicke mehr als zwei Schichtstrukturen aufweist, wobei jede Schichtstruktur eine auf Nb-Ti basierende Legierungsschicht (13) und eine Metallschicht (12) mit hoher Leitfähigkeit aufweist.

2. Supraleitende magnetische Abschirmung mit einem nahtlosen Hohlkörper mit einer Wand, die in Richtung ihrer Dicke eine Schichtstruktur aus einer oder mehreren auf Nb-Ti basierenden Legierungsschichten (13) mit einer Misch-Mikrostruktur aus einem kaltbearbeiteten Schichtanteil und einem $\alpha$-Ti-Präzipitations-Schichtanteil und eine oder mehrere Metallschichten (12) mit hoher Leitfähigkeit aufweist, wobei die Verbindung der Grenzflächen durch eine metallische Bindung erreicht wird.

3. Magnetische Abschirmung nach Anspruch 1 oder 2, wobei eine im Hohlkörper ausgebildete Öffnung durch einen Boden verschlossen ist, der die Schichtstruktur aufweist.

4.  Magnetische Abschirmung nach einem der Ansprüche 1 bis 3, wobei zwischen der auf Nb-Ti basierenden Legierungsschicht (13) und der Metallschicht (12) eine Sperrschicht (20) eingefügt ist.

5.  Magnetische Abschirmung nach einem der Ansprüche 1 bis 4, wobei das innerste Schichtelement und das äußerste Schichtelement jeweils eine Metallschicht (12) mit hoher Leitfähigkeit aufweisen.

6.  Magnetische Abschirmung nach einem der Ansprüche 1 bis 5, wobei die Metallschicht (12) mit hoher Leitfähigkeit Kupfer, eine Kupferlegierung, Aluminium oder eine Aluminiumlegierung aufweist.

7.  Magnetische Abschirmung nach Anspruch 6, wobei die Kupferlegierung aus Kupfer und mindestens einem Element aus der Gruppe Ag, Zn, Sn, Ni, Si, P, Mn, Zr, Cr und Al gebildet wird.

8.  Magnetische Abschirmung nach Anspruch 6, wobei die Aluminiumlegierung aus Aluminium und mindestens einem Element aus der Gruppe Ag, Zn, Sn, Ni, Si, P, Mn, Zr, Cr und Cu gebildet wird.

9.  Magnetische Abschirmung nach einem der Ansprüche 1 bis 8, wobei die Sperrschicht (20) Nb, Ta oder eine Nb-Ta-Legierung aufweist.

10. Magnetische Abschirmung nach einem der Ansprüche 1 bis 9, wobei mehrere Hohlkörper mit verschiedenen Außen- und Innendurchmessern übereinander angeordnet sind, um einen Hohlkörper mit großer Wanddicke zu bilden.

11. Verfahren zum Herstellen einer supraleitenden magnetischen Abschirmung, mit dem Schritt: Pressen einer Platte oder Folie mit einer Schichtstruktur aus einer auf Nb-Ti basierenden Legierungsschicht (13) und einer Metallschicht (12) mit hoher Leitfähigkeit, um einen nahtlosen Hohlbehälter mit Boden herzustellen.

12. Verfahren nach Anspruch 11, wobei die Schichtstruktur aus einer auf Nb-Ti basierenden Legierungsschicht, einer Sperrschicht und einer Metallschicht mit hoher Leitfähigkeit besteht.

13. Verfahren nach Anspruch 11 oder 12, wobei der Boden des Hohlbehälters ausgeschnitten ist, um einen bodenlosen Hohlkörper zu bilden.

14. Verfahren zum Herstellen einer supraleitenden Abschirmung, mit den Schritten: Bearbeiten eines säulenförmigen konzentrischen Schichtkörpers mit einer Schichtstruktur aus einer auf Nb-Ti basierenden Schicht (13) und einer Metallschicht (12) mit hoher Leitfähigkeit durch einen Rohrwalzprozeß, einen Extrudierprozeß, einen Formziehprozeß oder eine Kombination davon, um einen nahtlosen Hohlkörper herzustellen.

15. Verfahren nach Anspruch 14, wobei zwischen der auf Nb-Ti basierenden Legierungsschicht (13) und der Metallschicht (12) mit hoher Leitfähigkeit eine Sperrschicht (20) eingefügt ist.

16. Verfahren nach einem der Ansprüche 11 bis 15, wobei die supraleitende magnetische Abschirmung bei einer Temperatur von 300 bis 450°C und einer Verweilzeit von 2 bis 3000 Stunden erwärmt wird.

17. Verfahren nach Anspruch 16, wobei die magnetische Abschirmung nach der Wärmebehandlung einer Kaltbearbeitung bei einem Bearbeitungsanteil von 2 bis 90% unterzogen wird.

18. Verfahren zum Herstellen eines Materials für eine supraleitende magnetische Abschirmung mit den Schritten: Anordnen mindestens einer Metallschicht mit hoher Leitfähigkeit, auf der mindestens eine Lage aus einer mit einer Sperrschicht beschichteten Platte aus einer auf Nb-Ti basierenden Legierung aufgeschichtet ist, bei einer Packungsdichte von mindestens 60% in einen Hohlkörper, Verschließen des Endabschnitts des Hohlkörpers, Herstellen eines Vakuumzustandes im Innenraum des Hohlkörpers, um den Hohlkörper durch Schweißen abzudichten, um einen einstückigen Verbundkörper herzustellen, Warmumformen des einstückigen Verbundkörpers bei einem Bearbeitungsanteil von 30 bis 98% und einer Temperatur von 500 bis 1000°C, abwechselndes Wiederholen einer Wärmebehandlung bei einer Temperatur von 300 bis 450°C in sechs oder weniger Wiederholungsschritten bei einer Verweilzeit von 1 bis 168 Stunden pro Wiederholungsschritt und einer Kaltbearbeitung bei einem Bearbeitungsanteil von 30 bis 98% pro Wiederholungsschritt, um eine Platte oder Folie herzustellen, und Durchführen einer letzten Wärmebehandlung für die Platte oder Folie bei einer Temperatur von 300 bis 450°C und einer Verweilzeit von 2 bis 3000 Stunden.

**19.** Verfahren nach Anspruch 18, wobei die Platte oder Folie nach der letzten Wärmebehandlung einer Kaltbearbeitung bei einem Bearbeitungsanteil von 2 bis 30% unterzogen wird.

**Revendications**

**1.** Blindage magnétique supraconducteur comprenant une pièce creuse sans raccord ayant une paroi comprenant, dans la direction de son épaisseur, plus de deux structures stratifiées, chaque structure stratifiée comprenant une couche (13) en alliage à base de Nb-Ti et une couche métallique (12) de conductivité élevée.

**2.** Blindage magnétique supraconducteur comprenant une pièce creuse sans raccord ayant une paroi comprenant, dans la direction de son épaisseur, une structure stratifiée comprenant une ou plusieurs couches (13) en alliage à base de Nb-Ti ayant une microstructure mixte écrouie et à précipitation de $\alpha$-Ti, une ou plusieurs couches métalliques (12) de conductivité élevée avec des liaisons métalliques à chaque interface.

**3.** Blindage magnétique selon la revendication 1 ou 2, dans lequel une ouverture de ladite pièce creuse est fermée par un fond comprenant ladite structure stratifiée.

**4.** Blindage magnétique selon l'une quelconque des revendications 1 à 3, dans lequel une couche de séparation (20) est introduite entre ladite couche (13) en alliage à base de Nb-Ti et ladite couche métallique (12).

**5.** Blindage magnétique selon l'une quelconque des revendications 1 à 4, dans lequel l'élément formant la couche la plus intérieure et l'élément formant la couche le plus extérieure comportent chacun une couche métallique (12) de conductivité élevée.

**6.** Blindage magnétique selon l'une quelconque des revendications 1 à 5, dans lequel la couche métallique (12) de conductivité élevée comprend l'un quelconque des matériaux suivants : cuivre, alliages de cuivre, aluminium et alliages d'aluminium.

**7.** Blindage magnétique selon la revendication 6, dans lequel l'alliage de cuivre comprend du cuivre auquel on ajoute au moins un élément choisi dans l'ensemble constitué par Ag, Zn, Sn, Ni, Si, P, Mn, Zr, Cr et Al.

**8.** Blindage magnétique selon la revendication 6, dans lequel l'alliage d'aluminium comprend de l'aluminium auquel on ajoute au moins un élément choisi dans l'ensemble constitué par Ag, Zn, Sn, Ni, Si, P, Mn, Zr, Cr et Cu.

**9.** Blindage magnétique selon l'une quelconque des revendications 1 à 8, dans lequel ladite couche de séparation (20) comprend Nb, Ta ou un alliage de Nb-Ta.

**10.** Blindage magnétique selon l'une quelconque des revendications 1 à 9, dans lequel plusieurs desdites pièces creuses ayant un diamètre extérieur et un diamètre intérieur différents sont placées l'une au-dessus de l'autre pour former une pièce creuse ayant une grande épaisseur de paroi.

**11.** Procédé de préparation d'un blindage magnétique supraconducteur qui comprend une opération d'emboutissage d'une plaque ou feuille comprenant une structure stratifiée comprenant une couche (13) en alliage à base de Nb-Ti et une couche métallique (12) de conductivité élevée pour former une cuve creuse sans raccord ayant un fond.

**12.** Procédé selon la revendication 11, dans lequel ladite structure stratifiée comprend une couche d'alliage à base de Nb-Ti, une couche de séparation et une couche métallique de conductivité élevée.

**13.** Procédé selon la revendication 11 ou 12, dans lequel le fond de ladite cuve est découpé pour former une pièce creuse sans fond.

**14.** Procédé de préparation d'un blindage supraconducteur qui consiste à soumettre un composite en forme de pilier comprenant un stratifié concentrique d'une structure stratifiée comprenant une couche (13) en alliage à base de Nb-Ti et une couche métallique (12) de conductivité élevée à au moins une des opérations suivantes : enroulage en forme de tube, extrusion et étirage à travers une matrice pour former une pièce creuse sans raccord.

**15.** Procédé selon la revendication 14, dans lequel une couche de séparation (20) est introduite entre ladite couche (13) en alliage à base de Nb-Ti et ladite couche métallique (12) de conductivité élevée.

16. Procédé selon l'une quelconque des revendications 11 à 15, dans lequel ledit blindage magnétique supraconducteur est chauffé à une température de 300 à 450°C pendant une durée de 2 à 3 000 heures.

17. Procédé selon la revendication 16, dans lequel à la suite dudit traitement thermique, ledit blindage magnétique supraconducteur est soumis à un travail à froid avec un taux de déformation de 2 à 90 %.

18. Procédé de préparation d'un matériau de blindage magnétique supraconducteur qui consiste à garnir une pièce creuse comprenant au moins une couche métallique de conductivité élevée stratifiée d'au moins une feuille d'alliage à base de Nb-Ti recouverte d'une couche de séparation avec un taux de garnissage de 60 % ou plus, à fermer la partie d'extrémité de la pièce creuse, à créer le vide à l'intérieur de la pièce creuse pour fermer par soudage et préparer un composite intégré, à soumettre le composite intégré à un travail à chaud avec un taux de déformation de 30 à 98 %, à une température de 500 à 1 000°C, en répétant six fois en alternance ou moins un traitement thermique à une température de 300 à 450°C pendant 1 à 168 heures à la fois et à un travail à froid avec un taux de déformation de 30 à 98 % à la fois pour préparer une plaque ou une feuille, et soumettre la plaque ou la feuille à un traitement thermique final à une température de 300 à 450°C pendant 2 à 3 000 heures.

19. Procédé selon la revendication 18, dans lequel, après ledit traitement thermique final, ladite plaque ou feuille est soumise à un travail à froid avec un taux de déformation de 2 à 30 %, exclusivement.

# Fig.1a

12-1
13
12

15

# Fig.1b

12-1
13
12

16

# Fig.2a

3
2
1

# Fig.2b

3
2
1a

# Fig.3a

4
5
3
2

# Fig.3b

6
4
7
3
2

# Fig. 4a

# Fig. 4b

# Fig. 5

# Fig. 6

# Fig. 7

# Fig. 8

# Fig.9a

# Fig.9b

# Fig.10a

# Fig.10b

# Fig.10c

# Fig.11a

# Fig.11b

# Fig.12

# Fig. 13

# Fig. 14

# Fig. 15